# EUROPEAN PATENT APPLICATION

(11) **EP 4 482 271 A1**
(43) Date of publication of application: **25.12.2024**
(21) Application number: 24710331.0
(22) Date of filing: 08.02.2024
(51) Int. Cl.: H05K 7/20, H04M 1/02, F28D 15/02

(54) **HEAT DISSIPATION STRUCTURE AND ELECTRONIC DEVICE COMPRISING SAME**

(30) Priority: 04.05.2023 KR 20230058462; 15.06.2023 KR 20230076748
(71) Applicant: Samsung Electronics Co., Ltd., Suwon-si, Gyeonggi-do 16677 (KR)
(72) Inventor: SUNG, Jungoh, Suwon-si Gyeonggi-do 16677 (KR); KANG, Seunghoon, Suwon-si Gyeonggi-do 16677 (KR); KWON, Ohhyuck, Suwon-si Gyeonggi-do 16677 (KR); PARK, Yoonsun, Suwon-si Gyeonggi-do 16677 (KR); PARK, Jongkil, Suwon-si Gyeonggi-do 16677 (KR); SON, Changjong, Suwon-si Gyeonggi-do 16677 (KR)
(74) Representative: HGF
(86) International application number: PCT/KR2024/001926
(87) International publication number: WO 2024/228451

(57) **Abstract**

An electronic device of one embodiment may include a housing, at least one heat provision component disposed inside the housing, a heat dissipation structure disposed adjacent to the at least one heat provision component, and configured to absorb a heat provided by the at least one heat provision component and transmit or emit the heat in at least a first direction, and a support part extending from the housing and supporting at least part of the heat dissipation structure. The heat dissipation structure may include a first plate, a second plate facing the first plate, at least one first support member disposed in a first portion of the space between the first plate and the second plate, and a wick structure disposed in at least one of part of the first portion of the space between the first plate and the second plate or at least part of a second portion that is portion other than the first portion. The at least one first support member may be configured to contact with the first plate and the second plate, by arranging the wick structure in at least one of part of the first portion of the space or at least part of the second portion. The at least one first support member may be disposed to overlap at least partially with an edge of the support part.

In addition to this, various embodiments identified through the specification are possible.

## Description

### [Technical Field]

Various embodiments disclosed in the present document relate to a heat dissipation structure and an electronic device including the same.

### [Background Art]

As electronic devices are becoming smaller, their functions are becoming more diverse. Electrical components built into these electronic devices may be disposed so that distances with, or space between, surrounding structures may be gradually narrowed or concentrated so as to attain the miniaturization and slimness of the electronic devices. These electrical components can provide a high-temperature heat due to the execution of various functions. This high-temperature heat can cause the malfunction of the electronic devices, and cause a discomfort to users. Accordingly, the electronic device can include a heat dissipation structure, which can effectively diffuse a heat provided by the electrical components to the surroundings.

However, in view of the current slimness of electronic devices, such heat dissipation structures are often also designed to be thin, and may be disposed to extend over a large area inside the electronic device. Such heat dissipation structures may be vulnerable to damage, such as arising from external impact to the device. This may cause deformation of the heat dissipation structure which may impair performance of heat dissipation or transfer.

### [Disclosure of Invention]

### [Solution to Problem]

An electronic device of one embodiment may include a housing, at least one heat provision component disposed inside the housing, a heat dissipation structure disposed adjacent to the at least one heat provision component, and configured to absorb a heat provided by the at least one heat provision component and transmit or emit the heat in at least a first direction, and a support part extending from the housing and supporting at least part of the heat dissipation structure. The heat dissipation structure may include a first plate, a second plate facing the first plate, at least one first support member disposed in a first portion of the space between the first plate and the second plate, and a wick structure disposed in at least one of part of the first portion of the space between the first plate and the second plate or at least part of a second portion that is portion other than the first portion. The at least one first support member may be configured to contact with the first plate and the second plate, by arranging the wick structure in at least one of part of the first portion of the space or at least part of the second portion. The at least one first support member may be disposed to overlap at least partially with an edge of the support part.

As described above, a heat dissipation structure of one embodiment may include a first plate, a second plate facing the first plate, at least one first support member disposed in a first portion of the space between the first plate and the second plate, and a wick structure disposed in at least one of part of the first portion of the space between the first plate and the second plate or at least part of a second portion that is portion other than the first portion. The at least one first support member may be configured to contact with the first plate and the second plate, by arranging the wick structure in at least one of part of the first portion of the space or at least part of the second portion.

### [Brief Description of Drawings]

FIG. 1 is a perspective view illustrating a front of an electronic device according to one embodiment.
FIG. 2 is a perspective view illustrating a rear of the electronic device of FIG. 1.
FIG. 3A is an exploded perspective view of an electronic device according to one embodiment.
FIG. 3B is a perspective view illustrating the interior of an electronic device according to one embodiment.
FIG. 3C is a perspective view illustrating the interior of the electronic device of FIG. 3B.
FIG. 3D is a cross-sectional view of the electronic device 100 of FIG. 3A taken along line a-a'.
FIG. 4 is a plan view illustrating a heat dissipation structure according to one embodiment.
FIG. 5 is an exploded perspective view of a heat dissipation structure according to one embodiment.
FIG. 6 is a cross-sectional view of a heat dissipation structure viewed along line A-A' of FIG. 4 according to one embodiment.
FIG. 7 is a cross-sectional view of a heat dissipation structure according to one embodiment.
FIG. 8 is a plan view illustrating the interior of an electronic device including a heat dissipation structure according to one embodiment.
FIG. 9 is a cross-sectional view of a heat dissipation structure according to one embodiment.
FIG. 10 is a plan view of a heat dissipation structure according to one embodiment.
FIG. 11 is a cross-sectional view of a heat dissipation structure according to one embodiment.

In relation to the description of the drawings, the same or similar reference numerals may be used for the same or similar components.

### [Mode for the Invention]

Hereinafter, various embodiments of the present invention are described with reference to the accompanying drawings. However, this is not intended to limit the present invention to specific embodiments, and should be understood as including various modifications, equivalents, and/or alternatives to the embodiments of the present invention.

An electronic device of various embodiments of the present document may include at least one of, for example, a smartphone, a tablet personal computer (tablet PC), a mobile phone, a video phone, an e-book reader, a desktop personal computer (desktop PC), a laptop personal computer (laptop PC), a netbook computer, a workstation, a server, a personal digital assistant (PDA), a portable multimedia player (PMP), an MP3 player, a mobile medical device, a camera, or a wearable device. According to various embodiments, the wearable device may include at least one of an accessory type (e.g., a watch, a ring, a bracelet, an anklet, a necklace, glasses, contact lenses, or a head-mounted-device (HMD)), a fabric or clothing integrated type (e.g., an electronic garment), a body-attachable type (e.g., a skin pad or a tattoo), or a bio implantable type (e.g., an implantable circuit).

In some embodiments, the electronic device may be a home appliance. The home appliance may include at least one of, for example, a television set, a digital video disk (DVD) player, a stereo, a refrigerator, an air conditioner, a vacuum cleaner, an oven, a microwave oven, a washing machine, an air purifier, a set-top box, a home automation control panel, a security control panel, a TV box, a game console, an electronic dictionary, an electronic key, a camcorder, or an electronic picture frame.

In one embodiment, the electronic device may include at least one of various medical devices (e.g., various portable medical measurement devices (blood sugar monitor, heart rate monitor, blood pressure monitor, or body temperature monitor), a magnetic resonance angiography (MRA), a magnetic resonance imaging (MRI), a computer tomography (CT), an imaging device, or an ultrasonic device), a navigation device, a global navigation satellite system (GNSS), an event data recorder (EDR), a flight data recorder (FDR), an automobile infotainment device, a marine electronic equipment (e.g., a marine navigation system or a gyrocompass), avionics, a security device, a head unit for vehicle, an industrial or domestic robot, an automatic teller's machine (ATM) of a financial institution, a point of sales (POS) of a shop, or an Internet of things device (e.g., a light bulb, various sensors, an electric or gas meter, a sprinkler system, a fire alarm, a thermostat, a street light, a toaster, an exercise machine, a hot water tank, a heater, or a boiler).

According to some embodiment, the electronic device may include at least one of a piece of furniture or part of a building/structure, an electronic board, an electronic signature receiving device, a projector, or various measuring devices (e.g., water, electricity, gas, or radio wave measuring devices). In various embodiments, the electronic device may be one of the various devices described above or a combination of two or more. The electronic device of some embodiment may be a flexible electronic device. It will be appreciated that the above-detailed examples of electronic devices are non-limiting, and that the electronic device of an embodiment of the present document is not limited to the above-mentioned devices, and may include examples in addition to those discussed above, and may include a new electronic device according to technological developments.

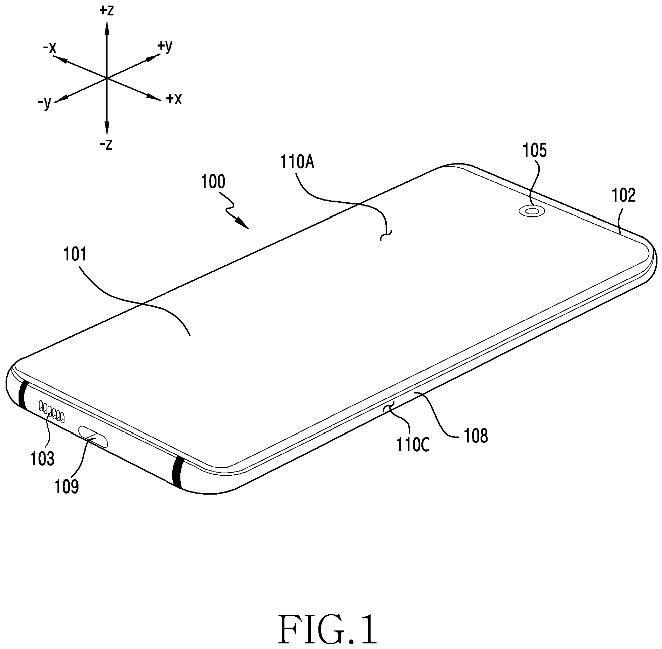

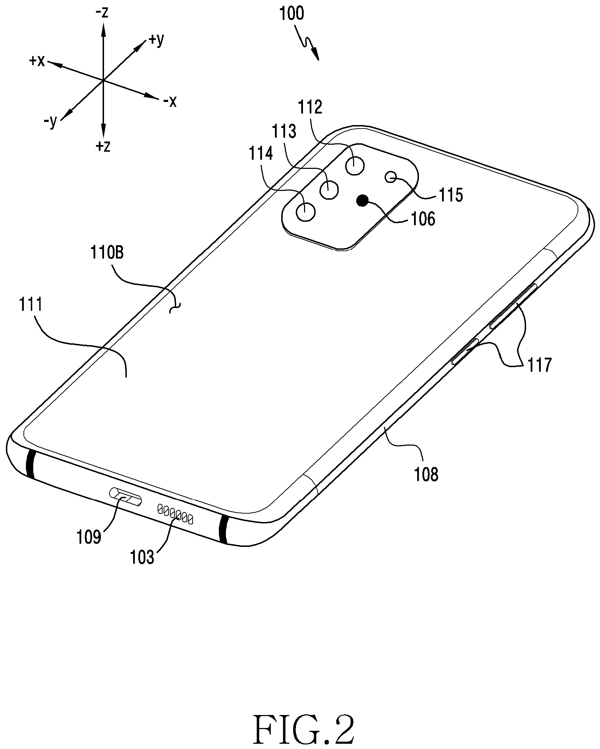

FIG. 1 is a perspective view illustrating a front of an electronic device 100 according to one embodiment, and FIG. 2 is a perspective view illustrating a rear of the electronic device 100 of FIG. 1.

The electronic device 100 of one embodiment of the present invention is described by taking a bar-type electronic device as an example but embodiments described later may also be applied to various electronic devices such as slideable, rollable, and foldable types, but are not limited thereto.

Referring to FIGS. 1 and 2, the electronic device 100 of one embodiment may include a housing 110 that includes a first surface (or "front surface") 110A, a second surface (or "rear surface") 110B, and a side surface (or "side wall") 110C surrounding a space between the first surface 110A and the second face 110B. In one embodiment (not shown), the housing 110 may also refer to a structure that forms some of the first surface 110A, the second surface 110B, and the side surface 110C of FIGS. 1 and 2.

According to one embodiment, the first surface 110A may be formed by a front plate 102 (e.g., a glass plate including various coating layers, or a polymer plate) of which at least a portion is substantially transparent. According to one embodiment, at least a side edge portion of the front plate 102 may include a curved portion that is bent and extended seamlessly from the first surface 110A toward a rear plate 111.

According to one embodiment, the second surface 110B may be formed by a substantially opaque rear plate 111. The rear plate 111 may be formed of, for example, coated or colored glass, ceramic, polymer, metal (e.g., aluminum, stainless steel (STS), or magnesium), or a combination of at least two of the above materials. According to one embodiment, at least a side edge portion of the rear plate 111 may include a curved portion that is bent and extended seamlessly from the second surface 110B toward the front plate 102.

According to one embodiment, the side surface 110C may be coupled to the front plate 102 and the rear plate 111, and be formed by a side member 108 including metal and/or polymer. In some embodiment, the rear plate 111 and the side member 108 may be formed as one piece and include the same material (e.g., a metallic material such as aluminum).

According to one embodiment, the electronic device 100 may include at least one of a display 101, an audio module 103, a sensor module (not shown), camera modules 115, 112, 113, and 106, key input devices 117, and a connector hole 109. In some embodiments, the electronic device 100 may omit at least one (e.g., the key input device 117) of the components described, or additionally include other components than those described.

In one example, the electronic device 100 may include a sensor module (not shown). For example, the sensor module may be disposed on the back of a screen display region of the display 101, which is visible to the outside of the electronic device 100 through the front plate 102.

For example, at least one of an optical sensor, an ultrasonic sensor, or a capacitive sensor may be disposed on the back of the screen display region of the display 101, but the present invention is not limited thereto.

In some embodiments, the electronic device 100 may further include a light emitting device, and the light emitting device may be disposed adjacent to the display 101 within a region presented by the front plate 102. For example, the light emitting device may present status information of the electronic device 100 in the form of light. In one embodiment, the light emitting device may present, for example, a light source linked to the operation of the camera module 105. The light emitting device may include, for example, an LED, an IR LED, and/or a xenon lamp.

According to one embodiment, the display 101 may be visible to the outside of the electronic device 100 through a significant portion of the front plate 102. In some embodiment, an edge of the display 101 may be formed to be substantially the same as an adjacent outer shape (e.g., a curved surface) of the front plate 102.

According to one embodiment (not shown), the electronic device 100 may form a recess, a notch, or an opening in part of the screen display region of the display 101, and various electronic components, for example, the camera module 105 or the sensor module (not shown) may be disposed in the recess, the notch, or the opening.

According to one embodiment (not shown), at least one of the camera modules (e.g., 112, 113, 114, 115), a fingerprint sensor, and a flash (e.g., 106) may be disposed on the back of the screen display region of the display 101. According to one embodiment (not shown), the display 101 may be coupled to or be disposed adjacent to a touch detection circuit, a pressure sensor capable of measuring the strength (pressure) of touch, and/or a digitizer detecting a magnetic field-type stylus pen.

According to one embodiment, the audio module 103 may include a microphone hole and a speaker hole. A microphone for acquiring external sound may be disposed inside the microphone hole, and in some embodiment, a plurality of microphones may be disposed to detect the direction of sound. According to one embodiment, the speaker hole and microphone hole may be implemented as one hole, or a speaker (e.g., a piezo speaker) may be also included without the speaker hole. The speaker hole may include, for example, an external speaker hole and a receiver hole for call.

By including the sensor module (not shown), the electronic device 100 may provide an electrical signal or data value corresponding to an internal operating state or an external environmental state. The sensor module may include a proximity sensor disposed on the first surface 110A of the housing 110, a fingerprint sensor disposed on the back of the display 101, and/or a biometric sensor (e.g., an HRM sensor) disposed on the second surface 110B of the housing 110.

The sensor module may further include at least one of a gesture sensor, a gyro sensor, a barometric pressure sensor, a magnetic sensor, an acceleration sensor, a grip sensor, a color sensor, an infrared (IR) sensor, a biometric sensor, a temperature sensor, a humidity sensor, and an illumination sensor, for example.

According to one embodiment, the camera modules 105, 112, 113, 114, 115, and 106 may include a first camera module 105 disposed on the first surface 110A of the electronic device 100, and second camera modules 112, 113, 114, and 115 disposed on the second surface 110B, and/or a flash 106. For example, the camera modules 105, 112, 113, 114, and 115 described above may include one or a plurality of lenses, an image sensor, and/or an image signal processor. The flash 106 may include, for example, a light emitting diode or a xenon lamp. In some embodiment, two or more lenses (an infrared camera, a wide-angle lens, and a telephoto lens) and image sensors may be disposed on one surface of the electronic device 100.

According to one embodiment, the key input devices 117 may be disposed on the side surface 110C of the housing 110. In one embodiment, the electronic device 100 may not include some or all of the key input devices 117 mentioned above, and the key input device 117 not included may be implemented in other forms such as a soft key on the display 101. In some embodiments, the key input devices 117 may include at least part of a fingerprint sensor disposed on the second surface 110B of the housing 110.

According to one embodiment, the connector hole 109 may accommodate a connector for transmitting and receiving power and/or data to and from an external electronic device, and/or a connector for transmitting and receiving an audio signal to and from the external electronic device. For example, the connector hole 109 may include a USB connector or an earphone jack. In one embodiment, the USB connector and earphone jack may be also implemented as one hole (e.g., 108 in FIGS. 1 and 2), and according to one embodiment (not shown), the electronic device 100 may transmit and receive power and/or data to and from the external electronic device without a separate connector hole, or may also transmit and receive an audio signal.

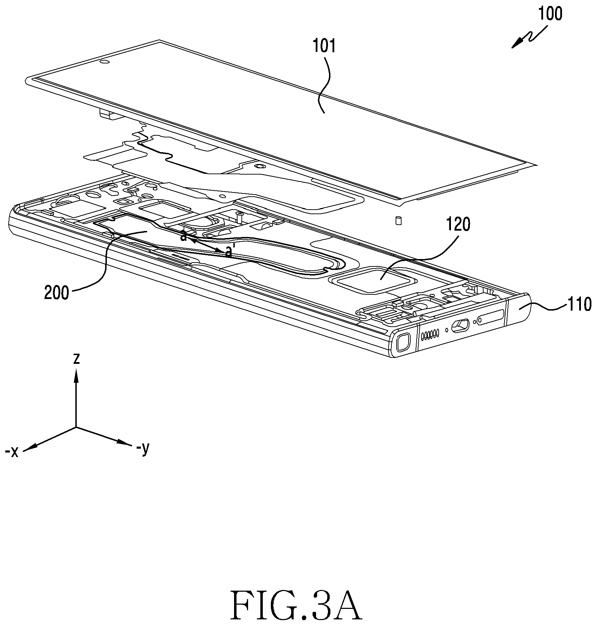

FIG. 3A is an exploded perspective view of an electronic device 100 according to one embodiment.

The electronic device 100 of FIG. 3A may be referenced by the electronic device 100 of FIGS. 1 and 2. For components (for example, the display 101 and the housing 110) that are the same or substantially the same as content described above, the same terms and/or the same reference numerals are used, and redundant content is omitted.

In FIG. 3A, the electronic device illustrates a portable electronic device, but the electronic device of various embodiments of the present disclosure is not limited thereto. For example, the electronic device of various embodiments of the present disclosure may include various electronic devices including at least one heat provision component.

In the examples described below, the term heat provision component may be used to describe a component (e.g. an electronic component) that may produce, emit, or generate heat when performing one or more functions (that is, during operation). In the examples described below, a heat provision component may also be described as a heat generating component, or heat emitting component.

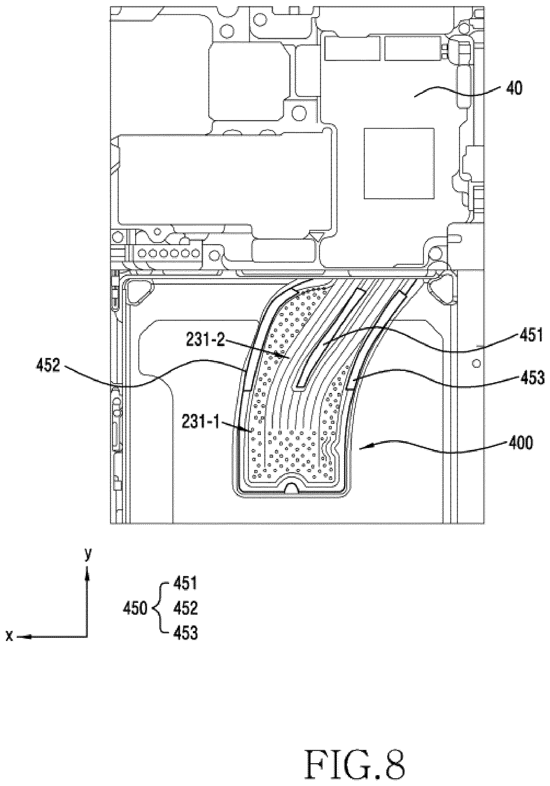

The electronic device 100 of one embodiment may include at least one heat provision component (for example, a heat provision component 40 of FIG. 8) disposed inside the housing 110. For example, the electronic device 100 may include a printed circuit board, and a plurality of electronic components may be disposed on the printed circuit board. Some of the plurality of electronic components, for example, an integrated circuit chip equipped with a processor or communication module, may provide a heat while operating. In examples, the heat provision, or heat generating, component may be a printed circuit board, PCB, or an integrated circuit, IC. However, the at least one heat provision component is not limited to this, and the at least one heat provision component may be one or more other components that provide, or generate, heat. The at least one heat provision component may be disposed inside the electronic device 100, and include various components that provide, or generate, a heat. The heat provided by the at least one heat provision component may reduce the operating performance of the heat provision component itself and/or the power efficiency of the electronic device 100. The electronic device 100 may include a heat dissipation structure such as (but not limited to) a heat transfer member, a heat pipe, and/or a vapor chamber, so as to disperse or emit a heat provided by the at least one heat provision component.

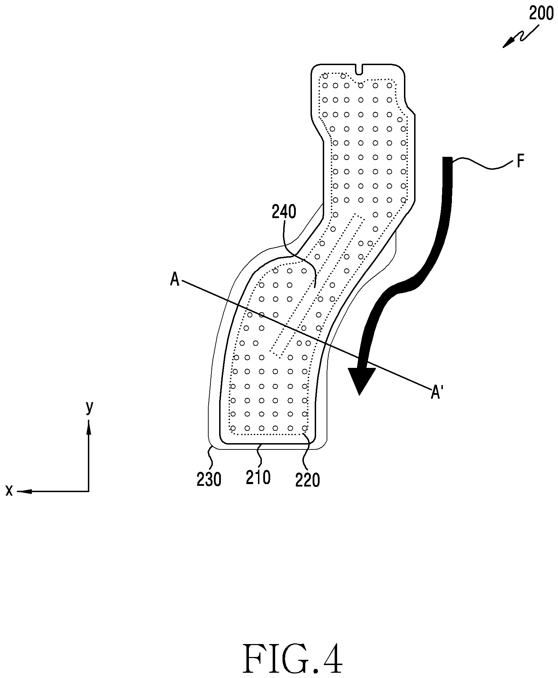

According to one embodiment, the electronic device 100 may include a heat dissipation structure. In an example, the electronic device 100 may include a vapor chamber 200 as the heat dissipation structure. The heat dissipation structure 200 may dissipate a heat provided by the at least one heat provision component to another region or another space within the interior of the electronic device 100 (for example, the interior of the housing 110). For example, the heat dissipation structure 200 may be configured to absorb a heat provided by the at least one heat provision component, and transfer or emit the heat in at least a first direction (for example, a y-axis direction in FIG. 3A, a direction (F) in FIG. 4, a longitudinal direction in which the heat dissipation structure 200 is disposed, or a longitudinal direction of, or in respect of, the electronic device 100). In various embodiments of the present disclosure, the longitudinal direction may refer to a direction of a long side of one member. However, the present invention is not limited to this.

According to one embodiment, the heat dissipation structure 200 may include a medium for transferring a heat therein. That is, the medium may transfer the heat in substantially at least a direction, e.g. a first direction, such as a longitudinal direction in respect of or with reference to the electronic device 100. For example, the heat dissipation structure 200 may include a cooling medium (or working fluid) as the medium therein. The medium (for example, the cooling medium) for transferring the heat may cause a phase change of the medium depending on an external temperature and absorb, disperse, or emit a heat provided by the at least one heat provision component. For example, a cooling medium of a liquid state may change into a gaseous state by absorbing a heat provided, or generated, by the at least one heat provision component, and a cooling medium of a gaseous state may change into a cooling medium of a liquid state by absorbing and emitting a heat provided by the at least one heat provision component to the outside while moving within the heat dissipation structure 200.

In an example, the cooling medium may circulate within the heat dissipation structure 200 through an opening of a wick structure (for example, a wick structure 220 of FIG. 4), based on a phase change (for example, a change from a liquid state to a gaseous state or a change from a gaseous state to a liquid state). Herein, an opening of a wick structure (e.g. a wick structure 220 as described in Figure 4) may be an internal passage (e.g. a phase path, or a space) through which the cooling medium (e.g. working fluid) may circulate, or move through. In one embodiment, the cooling medium may include at least one of water, a water-acetone mixture, or a water-ethanol mixture. However, the present invention is not limited to this.

According to one embodiment, the heat dissipation structure 200 may be disposed adjacent to the at least one heat provision component. In some examples, the heat dissipation structure 200 may cover at least part of the at least one heat provision component. In some examples, the heat dissipation structure 200 may fully cover, or overlap, the at least one heat provision components. In some examples, when looking at the heat dissipation structure 200 in a specified direction (for example, a direction viewed from the front of the electronic device 100 or a z-axis direction, or when viewed from above), the heat dissipation structure 200 may overlap at least partially with the at least one heat provision component.

According to one embodiment, the heat dissipation structure 200 may include a structure capable of (e.g. disposed to) transferring or emitting a heat provided by the at least one heat provision component. For example, referring to FIG. 3A, the heat dissipation structure 200 may be disposed with a first direction (for example, a longitudinal direction of the electronic device 100, a direction (F) of FIG. 4, or a y-axis direction) as a longitudinal direction. According to one embodiment, the heat dissipation structure 200 may include a structure disposed to be adjacent to the at least one heat provision component. In an example, the heat dissipation structure 200 may include a structure where at least a portion of the structure is curved. The heat dissipation structure 200 may be bent at least once or more. That is, the heat dissipation structure 200 may be disposed in view of the heat transfer direction being a longitudinal direction, and comprise a structure having at least one bend, or curve. However, the present invention is not limited to this.

According to one embodiment, at least part of the heat dissipation structure 200 may face at least one component For example, at least part of the heat dissipation structure 200 may face a battery 120. For example, at least part of one surface of the heat dissipation structure 200 may face at least one component (e.g. a battery 120). In some examples described herein, the at least part of the heat dissipation structure may be adjacent, next to, or overlap, the at least one component (e.g. a battery 120). However, the present invention is not limited to this. In examples, the heat dissipation structure 200 may face various components such as at least one electronic component (e.g., a speaker, a receiver, and a camera) or part of the housing 110.

In one example, when looking at the heat dissipation structure 200 in a specified direction (for example, a direction viewed from the rear of the electronic device 100 or a +z axis direction), the heat dissipation structure 200 may face at least one component. When the heat dissipation structure 200 (e.g. a surface of the heat dissipation structure) faces the at least one component, the heat dissipation structure 200 may be damaged by the at least one component. That is, in an example when an external impact is applied to the electronic device, the heat dissipation structure 200 may be damaged by contact, or impact, with the at least one component. In an example, when an external impact is applied to the electronic device 100, at least part of the heat dissipation structure 200 may be bent by an edge of the at least one component facing, or the shape of the heat dissipation structure 200 may be deformed.

According to one embodiment, to prevent the heat dissipation structure 200 from being damaged by the at least one component facing, the heat dissipation structure 200 may include at least one support member (for example, a first support member). The heat dissipation structure 200 includes at least one support member in a portion of the heat dissipation structure 200 (for example, a boundary that faces or overlaps, at least partially, the at least one component facing) vulnerable to damage, thereby being capable of preventing or reducing the damage of the heat dissipation structure 200 caused by an external impact of the electronic device 100. Detailed content on the at least one support member will be described later with reference to FIGS. 4 to 9.

In FIG. 3A, the electronic device 100 is shown as including one heat dissipation structure 200, but the number of heat dissipation structures 200 included in the electronic device 100 is not limited thereto. For example, the electronic device 100 may also include a plurality of heat dissipation structures 200.

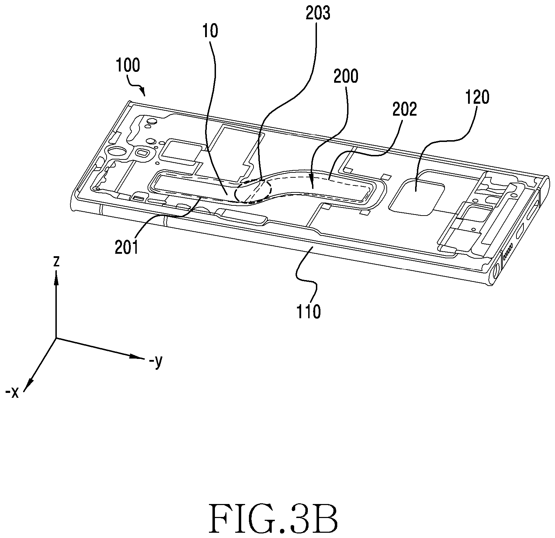

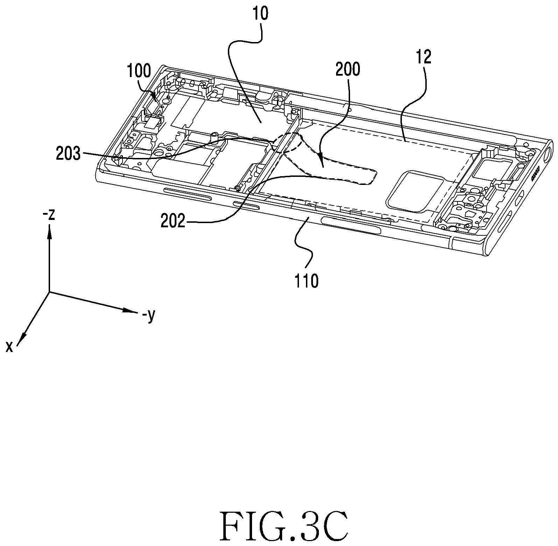

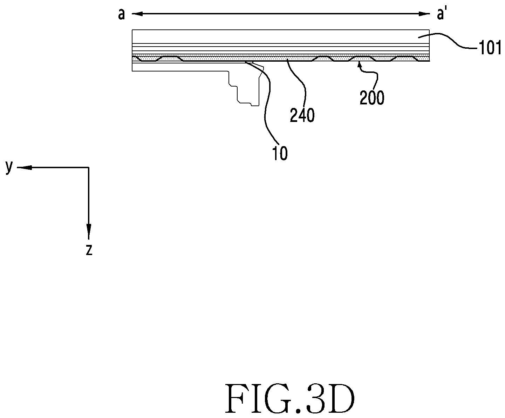

FIG. 3B is a perspective view illustrating the interior of an electronic device 100 according to one embodiment. FIG. 3C is a perspective view illustrating the interior of the electronic device 100 of FIG. 3B. FIG. 3D is a cross-sectional view of the electronic device 100 of FIG. 3A taken along line a-a' .

The electronic device 100 of FIGS. 3B, 3C, and 3D may be referenced by the electronic device 100 of FIG. 3A. For components that are the same or substantially the same as content described above, the same terms and/or reference numerals are used, and redundant descriptions are omitted.

FIG. 3B may be a diagram of the interior of the electronic device 100 in a direction (for example, -z direction) looking at a display (for example, the display 101 of FIG. 3A) of the electronic device 100. FIG. 3C may be a diagram of the interior of the electronic device 100 in a direction (for example, +z direction) looking at a rear plate (for example, the rear plate 111 of FIG. 2) of the electronic device 100.

Referring to FIGS. 3B and 3C, the electronic device 100 of one embodiment may include a heat dissipation structure 200. For example, the heat dissipation structure 200 may be disposed inside the housing 110.

According to one embodiment, the electronic device 100 may include a support part 10 extending from the housing 110 to support at least part of the heat dissipation structure 200. In some examples, the support part 10 may extend underneath, or below, at least a part of the heat dissipation structure 200 to support the at least part, e.g. when viewed from above, or a front, of the electronic device. The support part 10 may face (or overlap with) at least part of the heat dissipation structure 200.

In one embodiment, referring to FIG. 3B, at least part of the heat dissipation structure 200 may face the support part 10. For example, when looking at the electronic device 100 in a -z direction, at least part of the heat dissipation structure 200 may overlap with the support part 10.

In one embodiment, referring to FIG. 3C, at least part of the heat dissipation structure 200 may face at least one component (for example, the battery 120 of FIG. 3B). For example, when looking at the electronic device 100 in a +z direction, at least part of the heat dissipation structure 200 may overlap with the at least one component (for example, the battery 120). In an example, at least part (e.g. a first part) of the heat dissipation structure 200 may face the support part 10, and at least another part (e.g. a second part) of the heat dissipation structure 200 may face the at least one component (for example, the battery 120). A first region 12 of FIG. 3C may refer to a region of electronic device 100 where the at least one component (for example, the battery 120) is disposed.

Referring to FIGS. 3B, 3C, and 3D, the heat dissipation structure 200 of one embodiment may include a first part 201 facing the support part 10, a second part 202 facing the at least one component (for example, the battery 120), and a third part 203 disposed between the first part 201 and the second part 202. In one example, as shown in Figure 3B, a first part 201 and a second part 202 may correspond to, or comprise, opposite ends (areas) of the heat dissipation structure 200. In one example, the third part 203 may include a boundary portion of the first part 201 and the second part 202. For example, the third part 203 may comprise, or correspond to, the area between the first part 201 and the second part 202, and may comprise (or overlap) a boundary portion of each of the first part 201 and the second part 202. In one example, the third part 203 may include the part of the heat dissipation structure 200 that overlaps with an edge of the support part 10, and/or the part of the heat dissipation structure 200 that overlaps (e.g. at least partially overlaps) with an edge of the at least one component (for example, the battery 120).

In one embodiment, the third part 203 of the heat dissipation structure 200 may be vulnerable to deformation. For example, due to an external impact applied to the electronic device 100, the third part 203 of the heat dissipation structure 200 may be damaged by the edge of the support part 10 and/or the edge of the at least one component (for example, the battery 120).

In order to prevent or reduce the damage of the heat dissipation structure 200, the heat dissipation structure 200 of one embodiment may include at least one support member, e.g. at least one first, or internal, support member, (for example, a support member 240 of FIG. 3D) disposed in the third part 203. For example, the at least one support member 240 may overlap at least partially with the edge of at least one of the support part 10 or the at least one component (for example, the battery 120) that at least partially faces (or overlaps with) the heat dissipation structure 200. For example, the at least one support member 240 may be disposed across the third part 203 (or the edge of the support part 10). For example, the at least one support member 240 may be disposed to overlap at least partially with the edge of the support part 10. For example, part of the at least one support member 240 may be disposed in the first part 201 of the heat dissipation structure 200, and another part of the at least one support member 240 may be disposed in the second part 202 of the heat dissipation structure 200. Detailed content on the at least one support member 240 will be described later.

FIG. 4 is a plan view illustrating a heat dissipation structure 200 according to one embodiment.

The heat dissipation structure 200 of FIG. 4 may be referenced by the heat dissipation structure 200 of FIGS. 3A to 3D, and the description provided therein may similarly apply. For components that are the same or substantially the same as content described above, the same terms and/or the same reference numerals are used, and redundant content is omitted.

According to one embodiment, the heat dissipation structure 200 may include a first plate 210, a second plate 230 overlapping at least partially with the first plate 210, a wick structure 220 disposed between the first plate 210 and the second plate 230, and at least one first support member 240 disposed inside the heat dissipation structure 200. However, components of the heat dissipation structure 200 are not limited to these. For example, the heat dissipation structure 200 may omit at least one component among the components described above, or may further include at least one component. For example, the heat dissipation structure 200 may further include at least one side wall disposed in at least part of an edge of the space between the first plate 210 and the second plate 230, and/or at least one second support member disposed to face at least one of the first plate 210 or the second plate 230.

In one embodiment, the at least one first support member 240 may be disposed in a part of the heat dissipation structure 200 vulnerable to deformation.. In an example, , the first support member 240 may be disposed in a part of the heat dissipation structure 200 whose width is relatively narrow. For example, referring to FIG. 4, when the width of a part, adjacent to one end or the other end, of the heat dissipation structure 200 is greater than the width of a part, adjacent to the center, of the heat dissipation structure 200, the at least one first support member 240 may be disposed in the part, adjacent to the center, of the heat dissipation structure 200. That is, when the width of a part (or portion) of the heat dissipation structure 200 at either end is greater than the width of a part (or portion) of the heat dissipation structure 200 at the center, then the part at the center may be (more) vulnerable to deformation, and the at least one first support member may be disposed in the part adjacent to the center. That is, width of the part at the center is thinner than the width of the part at one end or the other end, and may be more vulnerable to deformation. In an example, with reference to Figures 3B-3D, as described above, the center may correspond to a third part 203 of the heat dissipation structure. However, the present invention is not limited to this. For example, the position of the at least one first support member 240 may change depending on the arrangement of at least one component that faces the heat dissipation structure 200 or contacts with the heat dissipation structure 200.

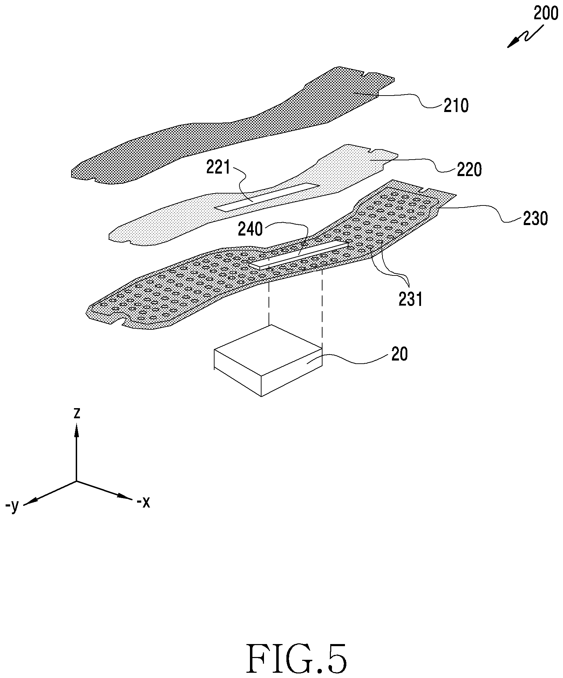

In one embodiment, the at least one first support member 240 may be disposed so as not to impede the movement of a medium for heat transfer (for example, a cooling medium or a working fluid) within the heat dissipation structure 200. For example, the at least one first support member 240 may be disposed to face a direction substantially parallel with a movement direction (for example, a direction (F)) of the heat transfer medium moving within the heat dissipation structure 200. In other words, the at least one support member 240 may be formed (disposed) in a shape to substantially correspond to the movement direction (e.g. a first direction) of the heat transfer medium. For example, the at least one first support member 240 may be disposed with a first direction (for example, a longitudinal direction of the first support member 240, a direction (F) of FIG. 4, or a y-axis direction of FIG. 5) as a longitudinal direction.

According to one embodiment, the at least one first support member 240 may have a bar shape. However, the present invention is not limited to this. For example, the at least one first support member 240 may be at least one of a polygonal shape or a cylindrical shape. In one example, the at least one first support member 240 may be a shape substantially the same as the shape of the movement direction (for example, the direction (F)) of the heat transfer medium moving within the heat dissipation structure 200. In one example, the at least one first support member 240 may be a shape that substantially corresponds to the heat dissipation structure 200. For example, the at least one first support member 240 may also include a curved portion.

FIG. 5 is an exploded perspective view of the heat dissipation structure 200 according to one embodiment.

The heat dissipation structure 200 of FIG. 5 may be referenced by the heat dissipation structure 200 of FIGS. 3A, 3B, 3C, 3D, and 4, and the description as provided in accordance with these Figures may similarly apply to the following description. For components that are the same or substantially the same as content described above, the same terms and/or the same reference numerals are used, and redundant descriptions are omitted.

Referring to FIG. 5, a first plate 210 may at least partially face a second plate 230. In one example, the first plate 210 at least partially faces (or at least partially contacts with) the second plate 230, whereby the space between the first plate 210 and the second plate 230 may be formed, e.g. forming a space therebetween. In one example, the space may be a closed space. However, the present invention is not limited to this.

According to one embodiment, at least one first support member 240 may be disposed in the space between the first plate 210 and the second plate 230. For example, the at least one first support member 240 may be disposed in a first portion of the space between the first plate 210 and the second plate 230. In one example, the first portion may mean at least one of a portion relatively vulnerable to damage or deformation in the heat dissipation structure 200 (see as described above with reference to FIG. 4), a portion not impeding the movement of a medium (for example, a cooling medium or working fluid) for transferring a heat within the heat dissipation structure 200 (see FIG. 4), and a portion overlapping at least partially with at least one component 20 that faces the heat dissipation structure 200 (for example, at least partially faces at least one of the first plate 210 or the second plate 230). In an example, the support member 240 may be disposed at a third part 203 of the heat dissipation structure, with reference to Figures 3B-3D. However, the present invention is not limited to this.

The at least one first support member 240 of one embodiment may be disposed to overlap at least partially with an edge of the at least one component 20. In an example, the at least one first support member 240 may be disposed so as to overlap at least partially with an edge of a support member 10 (as shown in Figure 3D, not shown in Figure 5). That is, in some examples the at least one first support member 240 (e.g. different parts, or portions, of) may overlap, at least partially, with an edge of the support part (10) and an edge of the at least one component (20).

In an example, as shown in Figure 5, when looking at the heat dissipation structure 200 in one direction (for example, z-axis direction), the at least one first support member 240 may be disposed to cross the edge of the at least one component 20 (for example, to cross in a y-axis direction). The edge of the at least one component 20 may include an edge that overlaps with at least one of the first plate 210 or the second plate 230. In FIG. 5, the at least one component 20 is shown as being disposed to face (or overlap with) the second plate 230, but the present invention is not limited thereto. For example, the at least one component 20 may be disposed to face (or overlap with) at least one of the first plate 210 or the second plate 230.

According to one embodiment, the first portion may include (or correspond to) a portion in which at least part of the wick structure 220 is removed. That is, in examples described in the present disclosure, at least part of the wick structure 220 is escaped, removed, or where at least part of the wick structure 220 is not formed, or is not disposed, at the first portion. That is, the first portion may include, or substantially correspond to, a portion where there is a space, or an opening, within the wick structure 220. For example, the first portion may include a portion, where the wick structure 220 is not disposed, in the space between the first plate 210 and the second plate 230. For example, referring to FIG. 5, the first portion may include (or correspond to) a portion in which at least part of the wick structure 220 is open (for example, open in a z-axis direction) to form an opening 221. The opening 221 may include a shape penetrating at least part of the wick structure 220. However, the first portion is not limited to the opening. Also, in FIG. 5, the first portion (for example, the opening 221) is shown as being disposed at the center of the wick structure 220, within the space between the first plate 210 and the second plate 230, but the present invention is not limited thereto. In examples, the first portion may include a portion corresponding to part where the at least one first support member 240 is disposed.

According to one embodiment, the wick structure 220 may be disposed in the space between the first plate 210 and the second plate 230. For example, the wick structure 220 may be disposed in at least part of a second portion of the space between the first plate 210 and the second plate 230. The second portion may be portion, other than the first portion, of the space between the first plate 210 and the second plate 230. However, the present invention is not limited to this. For example, the wick structure 220 may be also disposed in at least one of part of the first portion where the at least one first support member 240 is disposed or at least part of the second portion. For example, part of the wick structure 220 may be disposed in part of the first portion, and the remaining part of the wick structure 220 may be disposed in at least part of the second portion.

In FIG. 5, the heat dissipation structure 200 is shown as including one first support member 240, but the number and arrangement of the heat dissipation structures 200 are not limited to FIG. 5. According to one embodiment, the heat dissipation structure 200 may include a plurality of first support members 240. For example, the plurality of first support members 240 may be spaced apart from each other by a predetermined distance. For example, the plurality of first support members 240 may be disposed side by side along a longitudinal direction (for example, y-axis direction) of the heat dissipation structure 200, or may be disposed side by side along a width direction (for example, x-axis direction) of the heat dissipation structure 200. In some examples, the plurality of first support members 240 may be disposed to face, or in parallel with, a direction to correspond to the movement of the heat transfer medium. In one example, at least one first support member 240 may be disposed along the longitudinal direction of the heat dissipation structure 200, and other at least one first support member 240 may be also disposed side by side along the width direction of the heat dissipation structure 200.

According to one embodiment, as the number of first support members 240 included in the heat dissipation structure 200 changes, the shape and number of removed portions (for example, the openings 221) of the wick structure 220 may change. For example, the wick structure 220 may include a plurality of removed portions (for example, openings) corresponding (e.g. substantially corresponding) respectively to the plurality of first support members 240. However, the present invention is not limited to this. For example, the wick structure 220 may also include at least one or more removed portions corresponding (e.g. substantially corresponding) to the plurality of first support members 240.

According to one embodiment, the first portion of the space between the first plate 210 and the second plate 230 may be formed to correspond to the first support member 240. For example, the opening 221 of the wick structure 220 may be formed to correspond (e.g. substantially correspond) to the first support member 240. That is, the at least one first support member 240 may be disposed to contact the first plate and the second plate 230 through the opening 221 (e.g. extending through, or penetrating) of the wick structure. In one example, the size of the opening 221 may be larger than or substantially the same as the size of the first support member 240. However, the present invention is not limited to this.

According to one embodiment, the wick structure 220 includes the removed portion (for example, the opening 221) (or the wick structure 220 is disposed in the second portion of the space between the first plate 210 and the second plate 230), whereby the at least one first support member 240 may contact with the first support plate 210 and the second support plate 230.. For example, the at least one first support member 240 disposed in the second support plate 230 may contact with the first support plate 210, by penetrating (or extending through) the opening 221 of the wick structure 220.

The at least one first support member 240 contacts with (or joins) the first plate 210 and the second plate 230, whereby the rigidity of the heat dissipation structure 200 may be increased, and the damage or deformation of the heat dissipation structure 200 may be reduced. For example, the at least one first support member 240 contacts with (or joins) the first plate 210 and the second plate 230, whereby the shape of the heat dissipation structure 200 may be maintained from an external impact.

According to one embodiment, at least one of the first plate 210 or the second plate 230 may include metal. For example, at least one of the first plate 210 or the second plate 230 may include at least one of a copper alloy, a low-carbon stainless steel (e.g., 304L, 316L), or a titanium alloy. However, the present invention is not limited to this. For example, at least one of the first plate 210 or the second plate 230 may include various materials that are easy for mechanical processing (for example, stamping, pressing, or beading).

According to one embodiment, the wick structure 220 may include at least one of a plurality of wires, openings or passageways, in order to circulate a cooling medium (or working fluid) by using a high-temperature heat transferred from the first plate 210 and/or the second plate 230. For example, the wick structure 220 may also include at least one of a screen mesh made of copper, a woven wire, or a porous structure (for example, a laminate of metal powder) chemically formed in the space (for example, a closed space) between the first plate 210 and the second plate 230. However, the present invention is not limited to this.

In one embodiment, the wick structure 220 may include water as a working fluid. However, the present invention is not limited to this.

According to one embodiment, the wick structure 220 may have a capillary structure. The wick structure 220 may absorb a cooling medium of a liquid state. When the heat dissipation structure 200 is disposed, the wick structure 220 may be disposed adjacent to at least one heat provision component. The cooling medium absorbed by the wick structure 220 may absorb a heat provided by the heat provision component and cause a phase change. While circulating within the heat dissipation structure 200, the cooling medium absorbing the heat, for example, the cooling medium of the liquid state may cause a phase change again into a state capable of absorbing a heat provided by the heat provision component while emitting a heat in a region where a temperature is relatively low. The wick structure 220 may absorb the cooling medium of the liquid state by using the capillary structure and present an environment in which the cooling medium may be exposed to the heat provided by the heat provision component over a larger surface area. For example, the wick structure 220 may promote the phase change of the cooling medium. According to one embodiment, the wick structure 220 may have a shape for allowing a capillary pressure corresponding to an internal pressure and/or a flow resistance corresponding to a pressure drop of the cooling medium (or working fluid) to satisfy a specified value (e.g., a positive integer). For example, the wick structure 220 may have different capillary pressure and/or flow resistance depending on a wire structure or mesh structure, and accordingly, the shape (e.g., an opening width of the mesh structure) of the wick structure 220 may vary.

According to one embodiment, at least one of the first plate 210 or the second plate 230 may include a plurality of fillers, e.g. a plurality of pillars, 231. For example, referring to FIG. 5, the second plate 230 may include a plurality of fillers (e.g. pillars) 231. According to one embodiment, the plurality of fillers (e.g. pillars) 231 may be formed on at least one of the first plate 210 or the second plate 230 through mechanical processing (e.g., stamping, pressing, or beading).

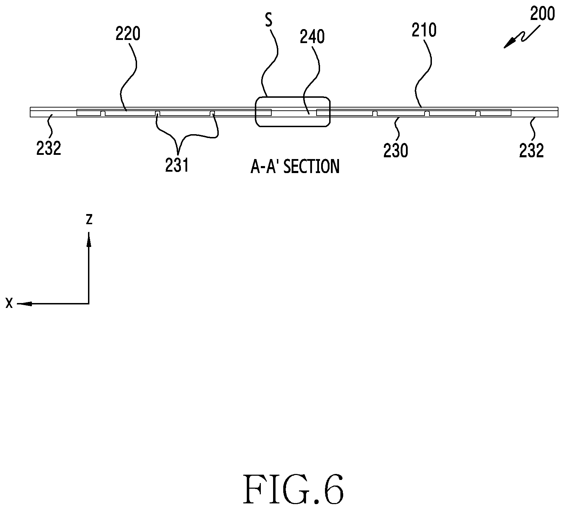

FIG. 6 is a cross-sectional view of the heat dissipation structure 200 taken along line A-A' of FIG. 4 according to one embodiment.

The heat dissipation structure 200 of FIG. 6 may be referenced by the heat dissipation structure 200 of FIGS. 3A to 5, and the description as provided in accordance with these Figures may similarly apply to the following description. For components that are the same or substantially the same as content described above, the same terms and/or the same reference numerals are used, and redundant content is omitted.

According to one embodiment, the heat dissipation structure 200 may include at least one side wall 232 that entirely or partially surrounds the space between the first plate 210 and the second plate 230. For example, the heat dissipation structure 200 may include at least one side wall 232 disposed in at least part of an edge of the space between the first plate 210 and the second plate 230. In FIG. 6, the heat dissipation structure 200 is shown as including one side wall 232 surrounding the space, but the heat dissipation structure 200 may also include at least two or more side walls.

According to one embodiment, the at least one side wall 232 may be in surface contact with at least one of the first plate 210 or the second plate 230. In one example, the at least one side wall 232 may be joined with at least one of the first plate 210 or the second plate 230 through a process such as brazing, diffusion bonding, soldering, or ultrasonic welding.

According to one embodiment, the at least one side wall 232 is disposed to surround the space between the first plate 210 and the second plate 230, whereby the space between the first plate 210 and the second plate 230 may be sealed, and the space may be maintained in a substantially vacuum state. In one example, the at least one side wall 232 is joined with at least one of the first plate 210 or the second plate 230 through a process such as brazing, diffusion bonding, soldering, or ultrasonic welding, whereby the space between the first plate 210 and the second plate 230 may be maintained in a substantially vacuum state.

According to one embodiment, the at least one side wall 232 may be formed integrally with at least one of the first plate 210 and the second plate 230. For example, referring to FIG. 6, the at least one side wall 232 may be formed integrally with the second plate 230, and be disposed to contact with the first plate 210. However, the present invention is not limited to this. For example, the at least one side wall 232 may be formed integrally with the first plate 210, and be disposed to contact with the second plate 230. For example, the at least one side wall 232 may be also a separate member from the first plate 210 and the second plate 230.

According to one embodiment, the at least one first support member 240 may be in surface contact with at least one of the first plate 210 or the second plate 230. In one example, the at least one first support member 240 may be joined with at least one of the first plate 210 or the second plate 230 through a process such as brazing, diffusion bonding, soldering, or ultrasonic welding.

According to one embodiment, the at least one first support member 240 may be formed integrally with at least one of the first plate 210 and the second plate 230. Referring to FIG. 6, the at least one first support member 240 may be formed integrally with the second plate 230, and be disposed to contact with the first plate 210. However, the present invention is not limited to this. In an example, the at least one first support member 240 may be formed integrally with the first plate 210, and be disposed to contact with the second plate 230. In another example, the at least one first support member 240 may be also a separate member from the first plate 210 and the second plate 230.

According to one embodiment, the first plate 210 may be spaced apart from the second plate 230 by a predetermined distance. At least one of the at least one side wall 232 or the at least one first support member 240 is disposed between the first plate 210 and the second plate 230, whereby the first plate 210 may be spaced apart from the second plate 230. At least one of the at least one side wall 232 or the at least one first support member 240 may be disposed between the first plate 210 and the second plate 230, whereby the first plate 210 and the second plate 230 may maintain a separation distance.

According to one embodiment, in FIG. 6, at least part of a wick structure 220 (for example, the wick structure 220 of FIG. 5) is escaped, or removed, in a region (S), whereby the at least one first support member 240 may contact with the first plate 210 and the second plate 230.

According to one embodiment, the plurality of fillers (e.g. a plurality of pillars) 231 may be formed to protrude (or extend) from at least one of the first plate 210 or the second plate 230 toward (for example, +z direction) the space between the first plate 210 and the second plate 230. That is, the plurality of fillers (e.g. pillars) 231 may protrude (or extend) from the first plate 210 toward the space between the first plate 210 and the second plate 230, and/or from the second plate 230 toward the space between the first plate 210 and the second plate 230. According to one embodiment, the plurality of fillers 231 may be formed to have a staggered type arrangement structure to reduce a flow resistance of a working fluid. In one embodiment, the plurality of fillers 231 may be also formed to have an inline type arrangement structure.

According to one embodiment, the plurality of fillers (e.g. pillars) 231 may contact with at least part of the wick structure 220 when the first plate 210 and the second plate 230 are joined. For example, the plurality of fillers 231 may be formed to have an amount of protrusion capable of at least partially contacting with the wick structure 220, when the first plate 210 and the second plate 230 are joined.

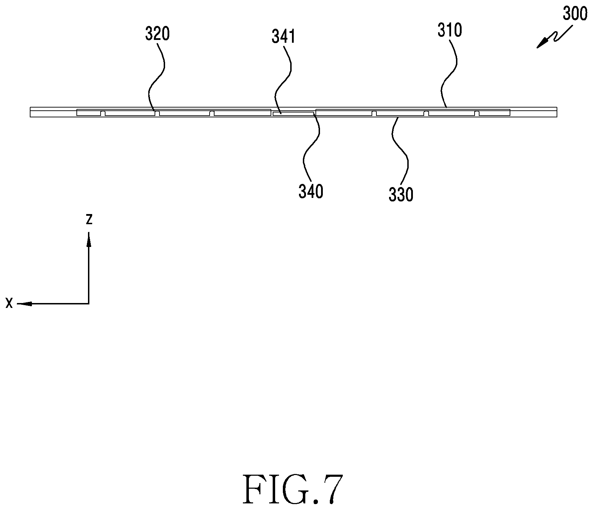

FIG. 7 is a cross-sectional view of a heat dissipation structure 300 according to one embodiment.

Herein, in the examples discussed, where the heat dissipation structure 300 of FIG. 7 is referenced, similarly, reference may be made to the heat dissipation structure 200 of FIGS. 3A to 6, and the description provided therein. That is, where components that are the same or substantially the same as content described above, the same terms are used, and redundant content is omitted.

Referring to FIG. 7, at least one first support member 340 may include at least one space 341 therein. The at least one space 341 may herein be also termed a spacer, or a path, in the below described examples. For example, referring to FIGS. 5 and 7, the at least one space 341 of the at least one first support member 340 may include at least one path that penetrates the first support member 340 in a first direction (for example, a longitudinal direction of the first support member 340, a direction (F) of FIG. 4 or a y-axis direction of FIG. 5). In one example, the space 341 of the first support member 340 may be used as a movement path for a cooling medium moving within the heat dissipation structure 300. As the cooling medium moves along the inside of the space 341, the cooling medium may absorb a heat provided by at least one heat provision component and emit the heat to the outside, thereby improving the heat dissipation performance of the heat dissipation structure 300.

In FIG. 7, the first support member 340 is shown as including one space 341 (or one path), but the present invention is not limited thereto. For example, the first support member 340 may also include a plurality of spaces (or a plurality of paths) penetrating in the first direction (for example, the longitudinal direction of the first support member 340, the direction (F) in FIG. 4, or the y-axis direction of FIG. 5).

According to one embodiment, the at least one first support member 340 may contact with the first plate 310 and the second plate 330. For example, the at least one first support member 340 may be fixed to at least one of the first plate 310 or the second plate 330, or be formed integrally with at least one of the first plate 310 or the second plate 330.

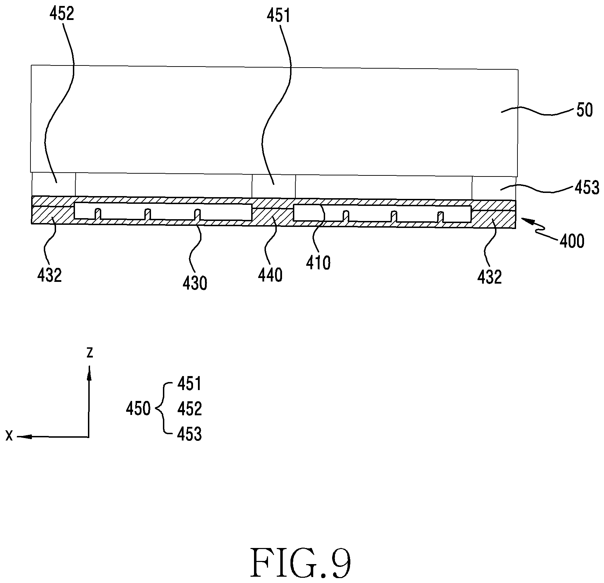

FIG. 8 is a plan view illustrating the interior of an electronic device including a heat dissipation structure 400 according to one embodiment. FIG. 9 is a cross-sectional view of the heat dissipation structure according to one embodiment.

Herein, where reference is made to the heat dissipation structure 400 of FIGS. 8 and 9, it will be appreciated that reference may also be made to the heat dissipation structure 200 of FIGS. 3A to 6 and/or the heat dissipation structure 300 of FIG. 7. The electronic device including the heat dissipation structure 400 of FIG. 8 may be referenced by the electronic device 100 of FIGS. 1 to 3C. Components that are the same or substantially the same as content described above use the same terms and/or the same reference numerals, and redundant content is omitted.

The electronic device 100 of one embodiment may include at least one heat provision component (or heat generating component) 40 disposed inside the housing 110. The heat dissipation structure 400 may be disposed adjacent to the at least one heat provision component 40. For example, referring to FIG. 8, when the electronic device 100 is viewed from above (for example, when looking in a +z direction), the heat dissipation structure 400 may overlap at least partially with the at least one heat provision component 40. The heat dissipation structure 400 may disperse or emit a heat provided by the at least one heat provision component 40.

According to one embodiment, the heat dissipation structure 400 may be disposed to face at least one component (for example, a component 50 of FIG. 9). For example, when the electronic device 100 is viewed from above (for example, when looking in the +z direction), at least part of portion not overlapping with the at least one heat provision component 40 of the heat dissipation structure 400 may be disposed to face the at least one component 50.

According to one embodiment, the heat dissipation structure 400 may be damaged by the at least one component 50. For example, the at least one component 50 facing the heat dissipation structure 400 presses at least part of the heat dissipation structure 400 (or around a filler of the heat dissipation structure 400), whereby the shape of the heat dissipation structure 400 may be deformed.

According to one embodiment, the electronic device may include a member for maintaining a separation distance between the at least one component 50 and the heat dissipation structure 400. For example, the electronic device may include at least one second support member 450 (e.g. the at least one second support member 450 external to the heat dissipation structure) disposed between the at least one component 50 and the heat dissipation structure 400. For example, the at least one second support member 450 may be disposed between a first plate (for example, a first plate 410 of FIG. 9) and the heat dissipation structure 400, or be disposed between a second plate (for example, a second plate 430 of FIG. 9) and the heat dissipation structure 400.

According to one embodiment, the at least one second support member 450 may overlap at least partially with at least one of at least one side wall (for example, a side wall 432 of FIG. 9) or at least one first support member (for example, a first support member 440 of FIG. 9). For example, the at least one second support member 450 may include at least one of a first member 451 that overlaps at least partially with the at least one first support member 440, a second member 452 that overlaps with at least part of the at least one side wall 432, or a third member 453 that overlaps with at least part of the at least one side wall 432 and faces the second member 452 with respect to the first member 451.

According to one embodiment, the at least one second support member 450 may correspond to at least one of the at least one side wall 432 or the at least one first support member 440. For example, the at least one first member 451 may include a shape corresponding to that of the first support member 440. For example, the at least one second member 452 may include a shape corresponding to at least part of the at least one side wall 432. For example, the at least one third member 453 may include a shape corresponding to at least part of the at least one side wall 432.

According to one embodiment, the heat dissipation structure 400 may include the at least one second support member 450. For example, the at least one second support member 450 may be formed integrally with at least one of the first plate 410 or the second plate 430.

According to one embodiment, the at least one first support member 440 and the at least one second support member 450 may be also formed integrally with at least one of the first plate 410 or the second plate 430.

According to one embodiment, the at least one second support member 450 may include at least one of a sponge or a rubber. However, the present invention is not limited to this. For example, the at least one second support member 450 may include the same material as at least one of the first plate 410 or the second plate 430.

According to one embodiment, the at least one second support member 450 may be disposed to overlap at least partially with an edge of the at least one component 50, which overlaps with at least one of the first plate 410 or the second plate 430. For example, when looking at the heat dissipation structure 400 in one direction (for example, z-axis direction), the at least one second support member 450 may be disposed to cross (or overlap) the edge of the at least one component 50 (for example, to cross in a y-axis direction).

According to one embodiment, the at least one component 50 may include a battery (for example, the battery 120 of FIG. 3A). However, the present invention is not limited to this. For example, the at least one component 50 may include various components disposed inside the electronic device, such as a speaker, a receiver, a camera, or part of a housing.

Referring to FIG. 8, the heat dissipation structure 400 of one embodiment may include a plurality of pillars. Reference may be made to the plurality of pillars 231 as referenced with respect to Figure 6.

In one embodiment, the plurality of pillars may include a first pillar 231-1 and a second pillar 231-2. In one embodiment, the plurality of pillars may include various shapes. For example, the first pillar 231-1 may include a dot shape, and the second pillar 231-2 may include a line shape.

In one example, the second pillar 231-2 (e.g. of the plurality of pillars) may be disposed parallel with at least one first support member (for example, the at least one first support member 440 of FIG. 9 or the at least one first support member 240 as described with reference to Figures 3-6). In examples herein, second pillar 231-2 may refer one or more pillars having a line shape. For example, the second pillar 231-2 may include a line shape pointing toward a direction substantially parallel with a longitudinal direction (for example, a direction (F) of FIG. 4 or a y-axis direction) of the at least one first support member 440.

According to one embodiment, the second pillar 231-2 may be disposed around at least one first support member (for example, the at least one first support member 440 of FIG. 9). For example, the second pillar 231-2 may be disposed to surround the at least one first support member 440. According to one embodiment, the second pillar 231-2 may improve the rigidity of the heat dissipation structure 400. The heat dissipation structure 400 includes the at least one first support member (for example, the first support member 440) and the second pillar 231-2, whereby the rigidity of the heat dissipation structure 400 may be increased.

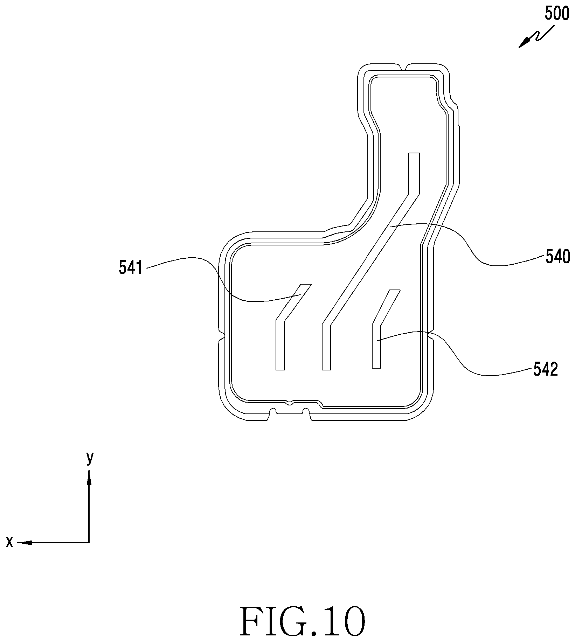

FIG. 10 is a plan view of a heat dissipation structure 500 according to one embodiment.

The heat dissipation structure 500 of FIG. 10 may be referenced by the heat dissipation structure 200 of FIGS. 3A to 6, the heat dissipation structure 300 of FIG. 7, and/or the heat dissipation structure 400 of FIGS. 8 and 9. For components that are the same or substantially the same as content described above, redundant descriptions are omitted.

Referring to FIG. 10, the heat dissipation structure 500 of one embodiment may include a plurality of support members. For example, the heat dissipation structure 500 may include a first support member 540, and a second support member 541 and a third support member 542 disposed with the first support member 540 interposed therebetween. The first support member 540 may be referenced by the first support member 240 of FIG. 4.

According to one embodiment, the second support member 541 may be spaced apart from the first support member 540 by a predetermined distance, and the third support member 542 may be spaced apart from the first support member 540 by a predetermined distance. In one example, a length by which the second support member 541 is spaced apart from the first support member 540 may be substantially equal to a length by which the third support member 542 is spaced apart from the first support member 540. However, the present invention is not limited to this. For example, positions of the plurality of support members may change depending on a position of at least one component facing the heat dissipation structure 500.

According to one embodiment, the second support member 541 may be symmetrical to the third support member 542 with respect to the first support member 540. However, the present invention is not limited to this.

According to one embodiment, the plurality of support members (for example, the first support member 540) may include a structure in which the heat dissipation structure 500 is not hindered from transferring or emitting a heat provided by at least one heat provision component. For example, the plurality of support members may be disposed with a first direction (for example, a longitudinal direction of the electronic device 100 of FIG. 1, a direction (F) of FIG. 4 or a y-axis direction) as a longitudinal direction. According to one embodiment, at least part of the plurality of support members may include a curved portion. For example, the plurality of support members may be bent at least once or more. For example, the plurality of support members may have a shape corresponding to the direction (F) of FIG. 4. However, the present invention is not limited to this.

According to one embodiment, the heat dissipation structure 500 includes the first support member 540, the second support member 541, and the third support member 542, whereby the rigidity of the heat dissipation structure 500 may be increased.

According to one embodiment, the heat dissipation structure 500 may have various shapes. For example, the shape of the heat dissipation structure 500 may change depending on a mounting space of an electronic device (for example, the electronic device 100 of FIG. 1). In one example, referring to FIG. 10, the heat dissipation structure 500 may include a rectangular shape including portion in which at least part of one edge is protruded in a +y-axis direction. However, the present invention is not limited to this.

According to one embodiment, the plurality of support members (for example, the second support member 541 and the third support member 542) may be disposed in the part of the heat dissipation structure 500 where a width (for example, a width of x-axis direction) of the heat dissipation structure 500 is larger. For example, when the heat dissipation structure 500 includes a first part having a first width in an x-axis direction and a second part having a second width greater than the first width in the x-axis direction, the plurality of support members (for example, the second support member 541 and the third support member 542) may be disposed in the second part. However, the present invention is not limited to this.

According to one embodiment, the number of the plurality of support members (for example, the second support member 541 and the third support member 542) disposed in the heat dissipation structure 500 may be more in the part of the heat dissipation structure 500 where the width (for example, the width of x-axis direction) of the heat dissipation structure 500 is larger. For example, when the heat dissipation structure 500 includes the first part having the first width in the x-axis direction and the second part having the second width greater than the first width in the x-axis direction, the number of the plurality of support members (for example, the second support member 541 and the third support member 542) may be more in the second part than in the first part. However, the present invention is not limited to this.

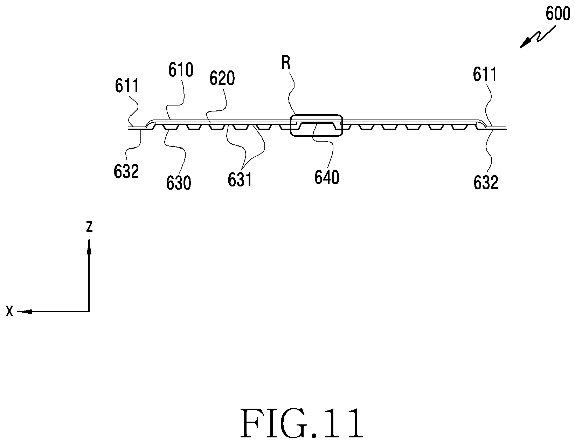

FIG. 11 is a cross-sectional view of a heat dissipation structure 600 according to one embodiment.

The heat dissipation structure 600 of FIG. 11 may be referenced by the heat dissipation structure 200 of FIGS. 3A to 6, the heat dissipation structure 300 of FIG. 7, the heat dissipation structure 400 of FIGS. 8 and 9, and/or the heat dissipation structure 500 of FIG. 10. For components that are the same or substantially the same as content described above, redundant descriptions are omitted.

Referring to FIG. 11, the heat dissipation structure 600 of one embodiment may include a first plate 610, a second plate 630 facing the first plate 610, and a wick structure 620 disposed between the first plate 610 and the second plate 630. In one embodiment, the second plate 630 may include a support part 640 that contacts with the first plate 610 and is bent in a direction toward the first plate 610. The second plate 630 may contact with the first plate 610 through the support part 640. The support part 640 may be referenced by the above-described first support member (for example, the first support member 240 of FIG. 4). The wick structure 620 may not be disposed in a first region (R). Content on the wick structure 620 may be referenced by the wick structure 220 of FIG. 6.

According to one embodiment, an edge 611 of the first plate 610 may contact with an edge 632 of the second plate 630. As the edge 611 of the first plate 610 and the edge 632 of the second plate 630 contact with each other, whereby a space may be formed between the first plate 610 and the second plate 630.

According to one embodiment, the heat dissipation structure 600 may be formed through a press process. For example, the support part 640 of the second plate 630 and/or a plurality of filler (e.g. pillar) portions 631 may be formed through a press process. For example, the support part 640 of the second plate 630 and/or the plurality of filler portions 631 may be formed by bending at least part of the second plate 630 through the press process. However, the present invention is not limited to this. For example, the heat dissipation structures of various embodiments may be also formed through an etching process.

As described above, an electronic device (for example, the electronic device 100 of FIG. 1) of one embodiment may include a housing (for example, the housing 110 of FIG. 1), at least one heat provision component disposed inside the housing, and a heat dissipation structure (for example, the heat dissipation structure of FIG. 3A) disposed adjacent to the at least one heat provision component, and configured to absorb a heat provided by the at least one heat provision component and transmit or emit the heat in at least a first direction. The heat dissipation structure may include a first plate (for example, the first plate 210 of FIG. 4), a second plate (for example, the second plate 230 of FIG. 4) facing the first plate, at least one first support member (for example, the first support member 240 of FIG. 4) disposed in a first portion of the space between the first plate and the second plate, and a wick structure (for example, the wick structure 220 of FIG. 5) disposed in at least part of a second portion that is portion other than the first portion. The at least one first support member may be configured to contact with the first plate and the second plate, by arranging the wick structure in at least part of the second portion of the space.

As described above, an electronic device (for example, the electronic device 100 of FIG. 1) of one embodiment may include a housing (for example, the housing 110 of FIG. 1), at least one heat provision component disposed inside the housing, a heat dissipation structure (for example, the heat dissipation structure 200 of FIG. 3A) disposed adjacent to the at least one heat provision component, and configured to absorb a heat provided by the at least one heat provision component and transmit or emit the heat in at least a first direction, and a support part (for example, the support part 10 of FIG. 3B) extending from the housing and supporting at least part of the heat dissipation structure. The heat dissipation structure may include a first plate, a second plate facing the first plate, at least one first support member (for example, the first support member 240 of FIG. 4) disposed in a first portion of the space between the first plate and the second plate, and a wick structure (for example, the wick structure 220 of FIG. 5) disposed in at least one of part of the first portion of the space between the first plate and the second plate or at least part of a second portion that is portion other than the first portion. The at least one first support member may be configured to contact with the first plate and the second plate, by arranging the wick structure in at least one of part of the first portion of the space or at least part of the second portion. The at least one first support member may be disposed to overlap at least partially with an edge of the support part.

According to one embodiment, the electronic device may include at least one component (for example, the battery 120 of FIG. 3A) disposed to at least partially face at least one of the first plate or the second plate. The at least one first support member may include a first part facing at least one of the at least one heat provision component or the support part, a second part facing the at least one component, and a third part disposed between the first part and the second part.

According to one embodiment, the electronic device may include at least one component (for example, the component 20 of FIG. 5) disposed to at least partially face at least one of the first plate or the second plate. The at least one first support member may be disposed to overlap at least partially with an edge of the at least one component, which overlaps with at least one of the first plate or the second plate.

According to one embodiment, the at least one first support member may be disposed to cross the edge of at least one of the at least one heat provision component or the support part.

According to one embodiment, the at least one first support member may be formed integrally with at least one of the first plate or the second plate.

According to one embodiment, the first support member may be disposed with the first direction as a longitudinal direction.

According to one embodiment, the heat dissipation structure may include at least one side wall (for example, the side wall 232 of FIG. 6) disposed in at least part of an edge of the space between the first plate and the second plate.

According to one embodiment, the at least one side wall may be formed integrally with at least one of the first plate or the second plate.

According to one embodiment, the electronic device may include at least one component (for example, the component 50 of FIG. 9) disposed to face the heat dissipation structure, and at least one second support member (for example, the second support member 450 of FIG. 8) disposed between the at least one component and the heat dissipation structure, and overlapping at least partially with at least one of the at least one side wall or the at least one first support member.

According to one embodiment, the at least one second support member may include at least one of a sponge or a rubber.

According to one embodiment, the at least one second support member may be disposed to overlap at least partially with an edge of the at least one component, which overlaps with at least one of the first plate or the second plate.

According to one embodiment, the at least one component (for example, the component of FIG. 9) may include a battery (for example, the battery 120 of FIG. 3A).

According to one embodiment, the heat dissipation structure may be formed with the first direction as a longitudinal direction.

According to one embodiment, the at least one first support member may include a path (for example, the path 341 of FIG. 7) penetrating in the first direction.

According to one embodiment, the second plate may include a plurality of fillers (for example, the plurality of fillers 231 of FIG. 5).

According to one embodiment, the plurality of fillers may contact with the wick structure.

As described above, a heat dissipation structure (for example, the heat dissipation structure 200 of FIG. 3A) of one embodiment may include a first plate (for example, the first plate 210 of FIG. 4), a second plate (for example, the second plate 230 of FIG. 4) facing the first plate, at least one first support member (for example, the first support member 240 of FIG. 4) disposed in a first portion of the space between the first plate and the second plate, and a wick structure (for example, the wick structure 220 of FIG. 5) disposed in at least one of part of the first portion of the space between the first plate and the second plate or at least part of a second portion that is portion other than the first portion. The at least one first support member may be configured to contact with the first plate and the second plate, by arranging the wick structure in at least one of part of the first portion of the space or at least part of the second portion.

According to one embodiment, the at least one first support member may be formed integrally with at least one of the first plate or the second plate.

According to one embodiment, the heat dissipation structure may include at least one side wall (for example, the side wall 232 of FIG. 6) disposed in at least part of an edge of the space between the first plate and the second plate.

According to one embodiment, the heat dissipation structure may further include at least one second support member (for example, the second support member 450 of FIG. 8) disposed to face at least one of the first plate or the second plate, and overlap at least partially with at least one of the at least one side wall or the first support member.

According to one embodiment, the at least one second support member may be formed integrally with at least one of the first plate or the second plate.
All of the examples, embodiments and features set out in this disclosure may be combined in any suitable manner unless described as incompatible or mutually exclusive. Furthermore, features of the various examples and embodiments may be omitted unless described as essential.

## Claims

1. An electronic device comprising:
a housing;
a heat generating component disposed in the housing;
a heat dissipation structure disposed adjacent to the heat generating component; and
a support part extending from the housing and supporting at least part of the heat dissipation structure,
wherein the heat dissipation structure comprises:
a first plate;
a second plate facing the first plate;
a first support member disposed in a first portion of a space between the first plate and the second plate; and
a wick structure disposed in a second portion of the space, wherein the second portion of the space is portion other than the first portion of the space, and
wherein the first support member is disposed to overlap at least partially with an edge of the support part.

2. The electronic device of claim 1, further comprising at least one component disposed to at least partially face at least one of the first plate or the second plate,
wherein the heat dissipation structure further comprises:
a first part facing at least one of the heat generating component or the support part;
a second part facing the at least one component; and
a third part disposed between the first part and the second part.

3. The electronic device of claim 2, wherein:
the wick structure comprises at least one opening; and
the first support member is disposed to contact the first plate and second plate through the opening of the wick structure.

4. The electronic device of claim 1, wherein the first support member is formed integrally with at least one of the first plate or the second plate.

5. The electronic device of claim 1, wherein the heat dissipation structure is configured to absorb a heat generated by the heat generating component and transfer the heat in at least a first direction,
wherein the first direction is a longitudinal direction in respect of the electronic device.

6. The electronic device of claim 1, wherein the heat dissipation structure comprises at least one side wall disposed in at least part of an edge of the space formed between the first plate and the second plate.

7. The electronic device of claim 6, wherein the at least one side wall is formed integrally with at least one of the first plate or the second plate.

8. The electronic device of claim 6, further comprising:
at least one component disposed to overlap with the heat dissipation structure; and
a second support member disposed between the at least one component and the heat dissipation structure, and overlapping at least partially with at least one of the at least one side wall or the first support member.

9. The electronic device of claim 1, wherein the wick structure disposed in a part of the first portion of the space.

10. The electronic device of claim 8, wherein the second support member is disposed to overlap at least partially with an edge of the at least one component, which overlaps with at least one of the first plate or the second plate.

11. The electronic device of claim 8, wherein the at least one component comprises a battery.

12. The electronic device of claim 1, wherein the heat dissipation structure is configured to absorb a heat generated by the heat generating component and transfer the heat in at least a first direction,
wherein the heat dissipation structure is disposed with the first direction as a longitudinal direction in respect of the electronic device.

13. The electronic device of claim 1, wherein the heat dissipation structure is configured to absorb a heat generated by the heat generating component and transfer the heat in at least a first direction,
wherein the first support member comprises one or more spacers penetrating the first support member in the first direction.

14. The electronic device of claim 1, wherein at least one of the first plate or the second plate comprises a plurality of pillars.

15. The electronic device of claim 14, wherein the plurality of pillars extend from the at least one of the first plate or the second plate to contact at least part of the wick structure.
